# EUROPEAN PATENT APPLICATION

(11) **EP 3 916 482 A1**
(43) Date of publication of application: **01.12.2021**
(21) Application number: 20176855.3
(22) Date of filing: 27.05.2020
(51) Int. Cl.: G03F 7/20, H01L 21/67, H01L 21/68, G03F 9/00

(54) **CONDITIONING DEVICE AND CORRESPONDING OBJECT HANDLER, STAGE APPARATUS AND LITHOGRAPHIC APPARATUS**

(71) Applicant: ASML Netherlands B.V., 5500 AH Veldhoven (NL)
(72) Inventor: VAN DONGEN, Paul, 5500 AH Veldhoven (NL); VAN BAREN, Martijn, 5500 AH Veldhoven (NL)
(74) Representative: ASML Netherlands B.V.

(57) **Abstract**

Conditioning device for conditioning an object in a conditioning volume, comprising: at least one support pin adapted to support the object; a first plate and a second plate forming outer borders of the conditioning volume; an actuator unit adapted to move at least one of the first plate and the second plate between: an object receiving position in which the first plate and second plate are separated by a receiving distance of each other and the object can be arranged into the conditioning volume; and an object conditioning position in which the first plate and second plate are separated by a conditioning distance of each other which is smaller than the receiving distance, wherein a seal is formed between the first plate and the second plate in the object conditioning position, wherein the seal forms an outer border of the conditioning volume.

## Description

### FIELD

The present invention relates to the conditioning of an object. In particular, the invention relates to a conditioning device, which can e.g. be part of an object handler, a stage apparatus or a lithographic apparatus. The invention also relates to a method for conditioning an object.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Before the pattern is projected on the substrate, the substrate is conditioned, e.g. by being cooled or heated to a predetermined temperature. The substrate may also be aligned, e.g. during the conditioning.

It is also known to electrostatically clamp the substrate on a high number, e.g. 500 or more, of burls, for heat transfer between a cooled or heated clamp and the substrate.

### SUMMARY

It is an object of the invention to provide an improved device and method for conditioning an object, or at least to provide an alternative for existing systems.

This object is achieved by a conditioning device for conditioning an object in a conditioning volume, comprising: at least one support pin adapted to support the object; and a first plate and a second plate forming outer borders of the conditioning volume. The conditioning device further comprises an actuator unit adapted to move at least one of the first plate and the second plate, between: an object receiving position in which the first plate and second plate are separated by a receiving distance of each other and the object can be arranged into the conditioning volume; and an object conditioning position in which the first plate and second plate are separated by a conditioning distance of each other which is smaller than the receiving distance, wherein a seal is formed between the first plate and the second plate in the object conditioning position, wherein the seal forms an outer border of the conditioning volume. The conditioning device further comprises at least one fluid outlet for supplying a conditioning fluid into the conditioning volume.

In the conditioning device according to the invention, the conditioning of the object is achieved by means of the conditioning fluid, and the first plate and the second plate. The first plate and the second plate are arranged relatively close to the object in the object conditioning position. The at least one support pin is provided primarily for support. The number of contact points between the conditioning device and the object can be reduced in comparison to known systems. The inventors have found that this is advantageous, because it reduces potential damage of the object. Furthermore, reducing the number of contact points also reduces the influence of unknown variables of the object such as material, electrical properties, and friction coefficient. In addition, because the at least one support pin is provided primarily for support, no electrostatic clamping is required. The inventors have found that electrostatic clamping may lead to damage due to electrostatic sticking of the object to the electrostatic clamp, which can be avoided with the present invention.

In an embodiment, the seal is a mechanical seal and/or a labyrinth seal, which is formed by the first plate and/or second plate when the first plate and/or the second plate are arranged in the object conditioning position. Advantageously, no additional components are required to form the seal, which reduces wear and maintenance. The seal may e.g. be a labyrinth seal.

In an embodiment, the conditioning device further comprises a control unit, wherein the control unit comprises an input terminal adapted to receive distance information representing a warpage of the object and/or an orientation of the object relative to the first plate and/or second plate. The control unit is further configured to determine a desired conditioning distance based on the distance information and control the actuator unit to arrange the first plate and/or second plate in the object conditioning position based on the desired conditioning distance. Advantageously, warpage and/or orientation of the object is taken into account and the first plate and second plate can be arranged relatively close to the object in any situation, which improves the transfer of thermal energy.

In an embodiment, the conditioning device further comprises a warpage measuring unit adapted to determine the distance information and adapted to send the distance information to the input terminal of the control unit. Advantageously, the actual warpage of the respective object can be taken into account.

In an embodiment, the conditioning device further comprises a control unit configured to control the supply of the conditioning fluid such that the pressure inside the conditioning volume, during operational use, can reach between 400-2200 Pa, preferably 600-2000 Pa, more preferably 700-1200 Pa, more preferably 900-1000 Pa. The inventors have found that these pressures are advantageous for the transfer of thermal energy, as well as for the requirements on components such as the seal.

In an embodiment, in the object receiving position a receiving opening is provided between the first plate and the second plate for arranging the object between the first plate and the second plate, wherein the receiving opening is between 5-25 mm, preferably 10-20 mm, more preferably 14-16 mm. The inventors have found that this is advantageous for receiving the object, in particular when the object is a substrate or wafer in lithographic applications, e.g. when the object is warped.

In an embodiment, the conditioning distance is between 0.8-2.5 mm, preferably 1-2 mm or 1-1.3 mm. The inventors have found that this is advantageous for receiving the object, in particular when the object is a substrate or wafer in lithographic applications. These embodiments also take into account possible warpage of the object, as well as tolerances in manufacturing and positioning of the object and components of the conditioning device.

In an embodiment, the first plate and/or the second plate are conditioning plates. This has been found to be advantageous for conditioning the object. For example, the first plate and/or second plate may be cooling plates.

In an embodiment, the conditioning device further comprises a liquid conditioning system adapted to condition the first plate and/or the second plate. Advantageously, the object releases thermal energy to the first plate and/or the second plate, which can in turn be released by means of the liquid conditioning system.

In an embodiment, the conditioning device further comprises a pre-cooling module adapted to decrease a temperature of the object before it is arranged in the conditioning volume. Advantageously the time that the object is required to remain in the conditioning volume can be decreased and/or the temperature to which the object can be conditioned can be reached more accurately.

In an embodiment, the conditioning device further comprises a pre-heating module adapted to increase a temperature of the object before it is arranged in the conditioning volume. Advantageously the time that the object is required to remain in the conditioning volume can be decreased and/or the temperature to which the object can be conditioned can be reached more accurately.

In an embodiment, the at least one support pin comprises one, two, three, four, five, or six support pins. Advantageously the number of contact points between the object and the conditioning device is relatively low.

In an embodiment, the at least one fluid outlet is provided in the first plate and/or in the second plate. Advantageously, a relatively simple construction is provided.

In an embodiment, the conditioning fluid comprises H₂, N₂, or Argon. These fluids have been found to be advantageous for conditioning the object accurately.

In an embodiment, the conditioning device is arranged in a vacuum environment having a pressure below atmospheric pressure. This has been found to be advantageous, in particular when the object is a wafer or substrate in a lithographic process wherein EUV radiation is emitted onto the object.

In an embodiment, the object is a reticle, a substrate or a wafer. The invention has been found to be advantageous for these applications.

In an embodiment, the conditioning device further comprises a second conditioning volume adapted to condition a second object in parallel or in series with the object, wherein the second conditioning volume is embodied analogously to the conditioning volume. Advantageously, the throughput can be increased.

The invention further relates to an object handler comprising a conditioning device according to the invention and an object pre-alignment module adapted to determine and/or control a position the object while it is being conditioned in the conditioning volume. Advantageously, the pre-alignment module and conditioning device are functional at the same time, decreasing the total time needed to handle the object and thereby increasing the throughput.

In an embodiment of the object handler according to the invention, the object pre-alignment module comprises a plurality of illuminators with each a corresponding camera for determining a position of the object, wherein the illuminators are each adapted to emit a measurement beam and each camera is adapted to receive the measurement beam emitted by the corresponding illuminator, wherein the first plate and/or the second plate comprise at least one beam-transparent region through which the measurement beams can travel. Advantageously, the position of the object can be determined. In an embodiment, the pre-alignment module comprises four illuminators and four cameras.

The invention further relates to a stage apparatus for receiving an object, said stage apparatus comprising an object table, an object handler according to the invention, and an object gripper adapted to receive the object from the handler and arrange the object above the object table. Advantageously, the object is conditioned using the conditioning device according to the invention before being arranged above the object table.

The invention further relates to a lithographic apparatus comprising a stage apparatus according to the invention for receiving an object comprising a substrate, wherein the lithographic apparatus is adapted to project a pattern from a patterning device onto the substrate. Advantageously, the object is conditioned using the conditioning device according to the invention before the pattern is projected onto the substrate.

The invention further relates to a method for conditioning an object in a conditioning device comprising a conditioning volume. The method may be performed using the conditioning device, object handler, stage apparatus, or lithographic apparatus according to the invention, but is not limited thereto. Nevertheless, any of the features explained herein with respect to the conditioning device, object handler, stage apparatus, or lithographic apparatus of the invention may be analogously applied to the method according to the invention, and vice versa.

The method comprises a step of arranging the object on at least one support pin while a first plate and a second plate which form outer borders of the conditioning volume are in an object receiving position in which the first plate and second plate are separated by a receiving distance of each other. The method further comprises a step of arranging the first plate and/or the second plate in an object conditioning position in which the first plate and second plate are separated by a conditioning distance of each other which is smaller than the receiving distance, wherein a seal is formed between the first plate and the second plate in the object conditioning position, wherein the seal forms an outer border of the conditioning volume. The method further comprises a step of supplying a conditioning fluid into the conditioning volume through at least one fluid outlet, and a step of removing the object from the conditioning device.

In the method according to the invention, the number of contact points between the conditioning device and the object can be reduced in comparison to known systems. The inventors have found that this is advantageous, because it reduces potential damage of the object. Furthermore, reducing the number of contact points also reduces the influence of unknown variables of the object such as material, electrical properties, and friction coefficient. In addition, because the at least one support pin is provided primarily for support, no electrostatic clamping is required. The inventors have found that electrostatic clamping may lead to electrostatic sticking of the object to the electrostatic clamp, which can be avoided with the present invention.

In an embodiment of the method according the invention, the object is removed from the conditioning device 4-15 seconds after inserting the object in the conditioning device, preferably after 5-13 seconds e.g. after 5-7 seconds, e.g. after 6 second, or e.g. after 11-13 seconds, e.g. 12 seconds. Advantageously the object spends relatively little time in the conditioning device, allowing for high throughput.

In an embodiment of the method according the invention, the object is removed from the conditioning device when a temperature of the object is within 3 mK a predetermined temperature, preferably within 2 mK, e.g. within 1.5 mK. Advantageously, the invention allows to conditioning the object very accurately.

In an embodiment, the invention relates to a method wherein use is made of a conditioning device according to the invention.

In an embodiment, the predetermined temperature is 18-25°C, e.g. 20, 21, or 22 °C

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2a schematically depicts a conditioning device according to the invention, wherein the first plate and the second plate are arranged in an object receiving position;
- Figure 2b schematically depicts the conditioning device shown in figure 2a, wherein the first plate and the second plate are arranged in an object conditioning position;
- Figure 3 illustrates a pre-alignment module of an object handler according to the invention;
- Figure 4 illustrates an object handler and a stage apparatus according to the invention;
- Figure 5 illustrates another embodiment of a conditioning device according to the invention.

### DETAILED DESCRIPTION

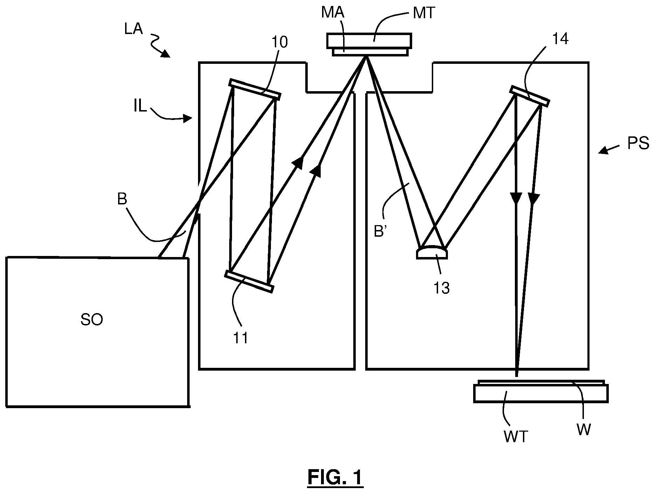

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

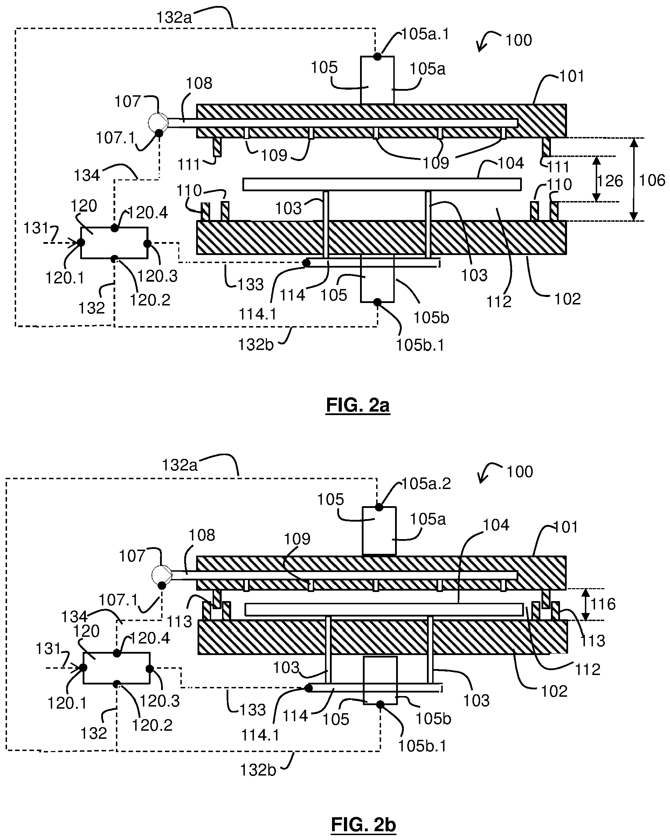

In order to project the pattern accurately on the substrate W, the position and the temperature of the substrate W must be controlled accurately. Fig. 2a-2b show a conditioning device 100 according to the invention. The conditioning device 100 can be used for conditioning an object 104 in a conditioning volume 112. The object 104 may e.g. be a substrate, a wafer, or an object comprising a substrate.

The conditioning device 100 comprises at least one support pin 103 adapted to support the object 104, and a first plate 101 and a second plate 102 forming outer borders of the conditioning volume 112. The conditioning device further comprises an actuator unit 105 adapted to move at least one of the first plate 101 and the second plate 102, between an object receiving position and an object conditioning position. The object receiving position is shown in fig. 2a, and the object conditioning position is shown in fig. 2b. In the object receiving position the first plate 101 and second plate 102 are separated by a receiving distance 106 of each other and the object 104 can be arranged into the conditioning volume 112. In the object conditioning position the first plate 101 and second plate 102 separated by a conditioning distance 116 of each other which is smaller than the receiving distance 106. Furthermore, a seal 113 is formed between the first plate 101 and the second plate 102 in the object conditioning position, wherein the seal 113 forms an outer border of the conditioning volume 112. The conditioning device 100 further comprises at least one fluid outlet 109 for supplying a conditioning fluid into the conditioning volume 112.

The invention further relates to a method for conditioning an object 104 in a conditioning device 100 comprising conditioning volume 112, wherein optionally use is made of a conditioning device 100 according to the invention. The method comprises a step of arranging the object 104 on at least one support pin 103 while a first plate 101 and a second plate 102 which form outer borders of the conditioning volume 112 are in an object receiving position in which the first plate 101 and second plate 102 are separated by a receiving distance 106 of each other. The method further comprises a step of arranging the first plate 101 and/or the second plate 102 in an object conditioning position in which the first plate 101 and second plate 102 are separated by a conditioning distance 116 of each other which is smaller than the receiving distance 106. A seal 113 is formed between the first plate 101 and the second plate 102 in the object conditioning position, wherein the seal 113 forms an outer border of the conditioning volume 112. The method further comprises a step of supplying a conditioning fluid into the conditioning volume 112 through at least one fluid outlet 109. The method further comprises a step of removing the object 104 from the conditioning device 100.

In the conditioning device 100 and method according to the invention, the conditioning of the object 104 is achieved by means of the conditioning fluid and the first plate 101 and the second plate 102. In this context, conditioning can e.g. be heating or cooling the object 104 to be within a predetermined range of a predetermined temperature. The first plate 101 and the second plate 102 are arranged relatively close to the object 104 in the object conditioning position, preferably without making contract with the object 104. The conditioning fluid may e.g. aid the transfer of thermal energy. The at least one support pin 103 is provided primarily for support. The number of contact points between the conditioning device 100 and the object 104 can be reduced in comparison to known systems. The inventors have found that this is advantageous, because it reduces potential damage of the object 104. Furthermore, reducing the number of contact points also reduces the influence of unknown variables of the object such as material, electrical properties, and friction coefficient In addition, the present invention may be advantageous in view of possible out-of-plane shape of the object 104. Said out-of-plane shape may e.g. occur when the object 104 is warped or bended. For example, recent trends in lithographic applications, such as addition of more layers on the substrate in vertical direction, may cause the object 104 to be warped.

In addition, because the at least one support pin 103 is provided primarily for support, no electrostatic clamping is required. The inventors have found that electrostatic clamping may lead to electrostatic sticking of the object 104 to the electrostatic clamp, which may lead to damaged. This can be avoided with the present invention.

In an embodiment, the object 104 is removed from the conditioning device 100 after 4-15 seconds, preferably after 5-13 seconds e.g. after 5-7 seconds, e.g. after 6 second, or e.g. after 11-13 seconds, e.g. 12 seconds. Advantageously the object 104 spends relatively little time the conditioning device, allowing for high throughput.

In an embodiment of the method according the invention, the object 104 is removed from the conditioning device 100 when a temperature of the object 104 is within 3 mK a predetermined temperature, preferably within 2 mK, e.g. within 1.5 mK. Advantageously, the invention allows to conditioning the object 104 very accurately. In an embodiment, the object 104 may be within 100 mK of the predetermined temperature before being entered in the conditioning device 100, e.g. at approximately 70 mK or 35 mK. The predetermined temperature may e.g. be 18-25°C, e.g. 20, 21, or 22 °C.

In an embodiment, the seal 113 is a mechanical seal and/or a labyrinth seal, which is formed by the first plate 101 and/or second plate 102 when the first plate 101 and/or the second plate 102 are arranged in the object conditioning position. As the seal 113 is formed by the first plate 101 and second plate 102, no additional components are required, which reduces wear. In the shown example, the first plate 101 comprises first plate protrusions 111 and the second plate 102 comprises second plate protrusions 110, which intermesh in the object conditioning position. In the object receiving position, no seal is present such that object 104 can be moved between the first plate protrusions 111 and the second plate protrusions 110 into the conditioning volume 112 above the at least one support pin 103. In an embodiment, the seal is a contactless seal. Thus, in this embodiment, there is no contact between the first plate 101 and the second plate 102. Avoiding contact reduces wear, e.g. of the first plate protrusions 111 and the second plate protrusions 110, and reduces the possibility that particles end up on the object 104. In an embodiment, the seal 113 is a straight seal, e.g. formed by a single protrusion from the first plate 101 or the second plate 102. In an embodiment, an elastomer seal may be provided between the first plate 101 and the second plate 102. In an embodiment, the seal 113 may be adapted such that a small amount of conditioning fluid flows out of the conditioning volume 112 via the seal, in operational use.

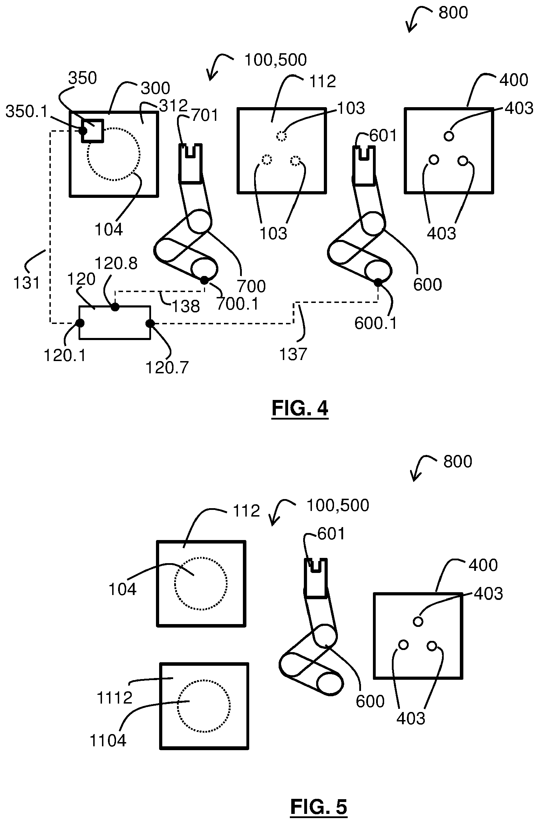

In an embodiment, the conditioning device 100 comprises a control unit 120. The control unit 120 comprises an input terminal 120.1 adapted to receive distance information 131 representing a warpage of the object 104 and/or an orientation of the object 104 relative to the first plate 101 and/or second plate 102. The control unit 120 is configured to determine a desired conditioning distance based on the distance information 131 and control the actuator unit 105 to arrange the first plate 101 and/or second plate 102 in the object conditioning position based on the desired conditioning distance. For example, the conditioning distance 116 may correspond with the desired conditioning distance or be within a predetermined range of the desired conditioning distance. The orientation of the object 104 relative to the first plate 101 and/or second plate 102 may e.g. include whether the object 104 and/or the first 101 and/or second plate 102 are tilted. Advantageously, the first plate 101 and the second plate 102 can be arranged relatively close to the object 104 in the object conditioning position, taking into account the actual warpage and/or orientation of the object 104. Advantageously, as the first plate 101 and the second plate 102 can be arranged closer to the object 104, the transfer of thermal energy is more efficient. In addition, the conditioning volume 112 is smaller is the object conditioning position, which means that less conditioning liquid is required. In an embodiment, the conditioning device 100 may comprise a warpage measuring unit, which will be explained further below with reference to fig. 4. In an embodiment, the distance information 131 may be determined in another module of a lithographic system in which the conditioning device is used. In an embodiment, the distance information 131 may be provided from a process control system, e.g. wherein an operator can input characteristics of the object 104 such as the distance information 131.

In the shown example, the actuator unit 105 comprises a first actuator 105a for moving the first plate 101 and a second actuator 105b for moving the second plate, but other arrangements are possible. For example, it may be possible to move only the first plate 101 or only the second plate 102.

In the shown example, the control unit 120 comprises an output terminal 120.2 for emitting an actuator control signal 132. The actuator control signal 132 comprises a first actuator control signal 132a which is send to an input terminal 105a.1 of the first actuator 105a for controlling the first actuator 105a, and a second actuator control signal 132b which is send to an input terminal 105b.1 of the second actuator 105b for controlling the second actuator 105b.

In an embodiment, the conditioning device 100 comprises a control unit 120 configured to control the supply of the conditioning fluid such that the pressure inside the conditioning volume 112, during operational use, can reach between 400-2200 Pa, preferably 600-2000 Pa, more preferably 700-1200 Pa, more preferably 900-1000 Pa. For completeness sake, it is noted that these pressures are absolute pressures. As the pressure is higher, the transfer of thermal energy is improved. However, at the same time more conditioning fluid is required and the requirements for to seal are more stringent to reduce leakage. The inventors have found that the pressures mentioned above are satisfactory for these diverging criteria.

In the shown example, the control unit 120 for controlling the supply of the conditioning fluid is the same control unit 120 that controls the actuator unit 105. In the shown example, the control unit 120 comprises an output terminal 120.4 for sending a fluid control signal 134 to an input terminal 107.1 of a compressor 107. As is schematically illustrated in fig. 2a-2b, the compressor 107 is adapted to make the conditioning fluid flow through a conduct 108 into the conditioning volume 112 via the at least one fluid outlet 109. It is noted that although in the shown example a compressor 107 is used, it is also possible that a pump is used, depending on the conditioning fluid. The compressor 107 may on a suction side (not shown) be fluidly connected to a fluid reservoir in which the conditioning fluid is stored, e.g. being pressurized. Optionally, the fluid reservoir is comprised by the conditioning device. It is also possible that the compressor 107 is fluidly connected to a conditioning fluid network, which may e.g. be present on the premises where the conditioning device 100 is used.

In the shown embodiment, the at least one fluid outlet 109 comprises five fluid outlets 109. However, any other suitable number of fluid outlets 109 may be provided. In the shown example, the at least one fluid outlet 109 is provided in the first plate 101, which is arranged above the object 104, during operational use. Advantageously, the conditioning fluid that is provide through the at least one fluid outlet 109 forces the object 104 against the at least one support pin 103. Alternatively or in combination, at least one fluid outlet may be provided in the second plate 102, wherein the second plate 102 is arranged below the object 104, during operational use.

In the shown embodiment, the conditioning fluid comprises H₂. Advantageously, H₂ allows conditioning the object 104 the accurately. For example, the object 104 may be conditioned to a temperature within 1K of a predetermined temperature, e.g. within 3 mK, e.g. within 1.5 mK. In other embodiments, the conditioning fluid may e.g. comprises N₂ or Argon.

In an embodiment, in the object receiving position a receiving opening 126 is provided between the first plate 101 and the second plate 102 for arranging the object 104 between the first plate 101 and the second plate 102. In an embodiment, the receiving opening 126 is between 5-25 mm, preferably 10-20 mm, more preferably 14-16 mm. It has been found that this allows to arrange the object 104 into the conditioning volume 112 easily, even when the object 104 is warped. For embodiments wherein the first plate protrusions 111 and/or the second plate protrusions 110 are present, it will be appreciated that their dimensions must be taken into account when determining the receiving opening 126. In an embodiment, the receiving opening 106 is such that a distance between the bottom of the first plate protrusions 111, and a top of the object 104 is between 5-10 mm, e.g. approximately 7 mm, in the object receiving position. In an embodiment, the receiving opening 106 is such that a distance between the top of the second plate protrusions 110, and a bottom of the object 104 is between 5-10 mm, e.g. approximately 7 mm, in the object receiving position.

In an embodiment, the conditioning distance is between 0.8-2.5 mm, preferably 1-2 mm. It has been found that this allows for efficient transfer of thermal energy, while taking into account possible warpage and/or orientation of the object 104, as well as tolerances and inaccuracies, e.g. in manufacturing of the first plate 101 and second plate 102, calibrations, and positioning of the first plate 101 and/or second plate 102 with the actuator unit 105. In an embodiment, the conditioning distance 116 is such that a distance between the bottom of the first plate 101, and a top of the object 104 is between 0.2-1 mm, e.g. approximately 0.4 mm or 0.6 mm, in the object conditioning position. In an embodiment, the conditioning distance 116 is such that a distance between the top of the second plate 102 and a bottom of the object 104 is between 0.2-1 mm, e.g. approximately 0.4 mm or 0.6 mm, in the object conditioning position.

In the shown embodiment, the at least one support pin 103 includes three support pins 103, of which two are visible in the view shown fig. 2a-2b. In other embodiments, the at least one support pin 103 comprises one, two, four, five, or six support pins 103.

Fig. 2a-2b further show that optionally the control unit 120 comprises an output terminal 120.3 for sending a pin control signal 133 to an input terminal 114.1 of a support pin actuator 114. The support pin actuator 114 is adapted to move the at least one support pin 103, e.g. when the object 104 is being arranged in the conditioning volume 112 or being removed from the conditioning volume 112. For example, the object 104 may be arranged between the first plate 101 and the second plate 102 by an object gripper while the at least one support pin 103 is retracted. The control unit 120 may then control the support pin actuator 114 to move the at least one support pin 103 upwards until the object 104 is supported by the at least one support pin 103. The object gripper may then be retracted, resulting in the situation shown in fig. 2a. In an embodiment, the at least one support pin 103 is able to rotate.

In an embodiment, the first plate 101 and/or the second plate 102 are conditioning plates. For example, the first plate 101 and/or the second plate 102 may be arranged to have a temperature that is lower or higher than a temperature of the object 104, such that the object 104 is conditioned by the first plate 101 and/or the second plate 102.

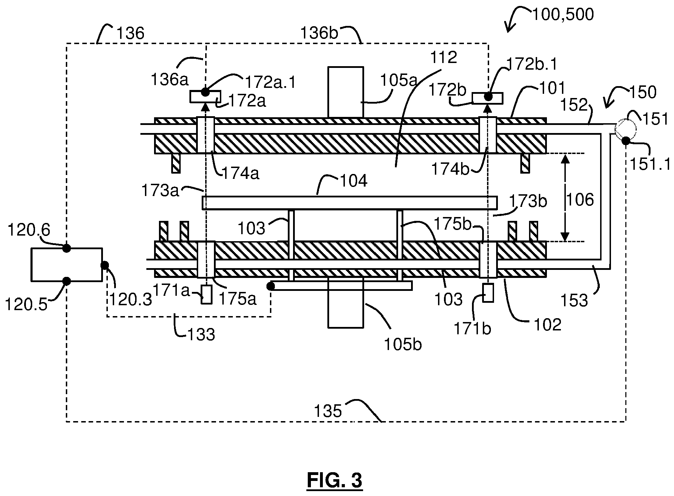

Fig. 3 illustrates that in an embodiment, the conditioning device 100 further comprises a liquid conditioning system 150 adapted to condition the first plate 101 and/or the second plate 102. In the shown example, the liquid conditioning system 150 comprises a pump 151 which pumps a cooling liquid through a first conduct 152 and a second conduct 153. The cooling liquid in the first conduct 152 absorbs thermal energy from the first plate 101 and the cooling liquid in the second conduct 153 absorbs thermal energy from the second plate 102. Although not shown in fig. 3, it will be appreciated that the liquid cooling system 150 may be a closed system, wherein the cooling liquid can be further transported and the thermal energy can be released, e.g. by changing the pressure of the cooling liquid and/or by means of a heat exchanger. Fig. 3 further illustrates that optionally the control unit 120 is configured to control the pump 151 with a conditioning control signal 135 that is transmitted from output terminal 120.5 to input terminal 151.1.

The invention further relates to an object handler 500 which comprises the conditioning device 100 according the invention. The object handler 500 may further comprise an object pre-alignment module adapted to determine and/or control a position the object 104 while it is being conditioned in the conditioning volume 112.

In an embodiment, the object pre-alignment module may be embodied similarly to the device for alignment of a substrate disclosed in US7307695B2 and/or comprise one or more features of said device. US7307695B2 is incorporated herein by reference.

In an embodiment as shown in fig. 3, the pre-alignment module comprises a plurality of illuminators 171a, 171b with each a corresponding camera 172a, 172b for determining a position of the object 104. The illuminators 171a, 171b are each adapted to emit a measurement beam 173a, 173b, and each camera 172a, 172b is adapted to receive the measurement beam 173a, 173b emitted by the corresponding illuminator 171a, 172b. The first plate 101 and/or the second plate 102 comprise at least one beam-transparent region 174a, 174b, 175a, 175b, through which the measurement beams 173a, 173b can travel.

In the shown example, the pre-alignment module comprises four of illuminators 171a, 171b and four cameras 172a, 172b, of which two are visible in the view in fig. 3 and the other two are arranged behind the visible illuminators 171a, 171b and cameras 172a, 172b. However, any other suitable number of illuminators 171a, 171b and cameras 172a, 172b are possible, e.g. three, four, five or six.

As illustrated in fig. 3, the position of the object 104 affects a first measurement beam 173a and a second measurement beam 173b, since the object 104 can be arranged in or out of the optical path of each respective measurement beam 173a, 173b. This can be detected by a first camera 172a which receives the first measurement beam 173a emitted by a first illuminator 171a and a second camera 172b which receives the second measurement beam 173b emitted by a second illuminator 171b. The first camera 172a emits a first detection signal 136a via an output terminal 172a.1, and the second camera 172b emits a second detection signal 136b via an output terminal 172b.1. Optionally, a detection signal 136 comprising the first detection signal 136a and the second detection signal 136b is transmitted to an input terminal 120.6 of the control unit 120. The control unit 120 is adapted to determine the position of the object 104 based on the detection signal 136. Optionally, the control unit 120 is further configured to control the position of the object 104 to pre-align the object 104. For example, the support pin actuator 114 may be able to be moved in a horizontal direction or to move the at least one support pin 103 in a horizontal direction.

Fig. 4 schematically shows a top view of the invention, wherein several features which are not essential for the following explanation have been omitted for the sake of clarity. In fig. 4, the conditioning volume 112 is indicated, and it can be seen that in the shown embodiment the condition device 100 comprises three support pins 103. Fig. 4 further shows that optionally the conditioning device 100 comprises a pre-condition module 300.

In an embodiment the pre-conditioning module 300 is pre-cooling module 300 adapted to decrease a temperature of the object 104 before it is arranged in the conditioning volume 112. In this embodiment, the object 104 is required to be positioned for a shorter time in the conditioning volume 112 to be cooled to a predetermined temperature, since the object 104 is already closer to said predetermined temperature before being arranged in the conditioning volume 112. As such, the throughput of the conditioning device 100 can be improved. For example, the object 104 may be arranged in the conditioning volume 112 for 6 seconds. For example, the temperature of the object 104 may within approximately 35 mK of the predetermined temperature before being arranged in the conditioning volume 112, and e.g. within 1.5 mK when being removed from the conditioning volume 112.

In an embodiment, the pre-conditioning module 300 is pre-heating module 300 adapted to increase a temperature of the object 104 before it is arranged in the conditioning volume 112. Increasing the temperature of the object 104 before arranging the object 104 in the conditioning volume 112 results in a faster response to the conditioning in the conditioning volume 112.

Fig. 4 further shows that optionally a warpage measuring unit 350 is arranged in the pre-conditioning module 300. The warpage measuring unit 350 adapted to determine the distance information 131 and adapted to send the distance information 131 via output terminal to the input terminal 120.1 of the control unit 120. The warpage measuring unit 350 may determine the distance information 131 using known methods to e.g. measure the warpage and/or orientation of the object 104, which the skilled person knows how to implement. It is noted that the warpage measuring unit 350 may also be arranged on any other suitable location in the conditioning device 100 or object handler 500.

The invention further relates to a stage apparatus 800 for receiving an object 104. The stage apparatus 800 comprises an object table 400, an object handler 500 according to the invention which comprises the conditioning device 100 according to the invention, and an object gripper 600 adapted to receive the object 104 from the object handler 500 and arrange the object 104 above the object table 403.

The object table 403 may e.g. correspond with the substrate table WT shown in fig. 1. With reference to fig. 1 and fig. 4, the invention further relates to a lithographic apparatus LA comprising a stage apparatus 800 according to the invention for receiving an object 104 comprising a substrate W, wherein the lithographic apparatus LA is adapted to project a pattern from a patterning device MA onto the substrate W.

Optionally, the conditioning device 100 and/or the object handler 500 and/or the stage apparatus 800 and/or the lithographic apparatus LA may be arranged in a vacuum environment having a pressure below atmospheric pressure, e.g. having a pressure below 10 Pa, e.g. approximately 2 Pa. This may e.g. be the case when the lithographic apparatus LA is configured to emit a radiation beam B comprising EUV radiation. It is noted that in these embodiments, the pressure inside the conditioning volume 112 may be greater than the pressure outside of the conditioning volume 112, during operational use.

Fig. 4 shows that in an embodiment the first object gripper 600 may comprise a first object support 601 which can receive the object 104 from the support pins 103. The first object gripper 600 is a multi-axis robot which allows moving the object 104 above the object table 400. The stage apparatus comprises three stage support pins 403 for supporting the object 104 when it is arranged above the object table 400. Fig. 4 further shows that optionally the first object gripper 600 is controlled by the control unit 120 which sends a control signal 137 via output terminal 120.7 to input terminal 600.1.

The conditioning device 100 optionally comprises a second object gripper 700 adapted to arrange the object 104 above the support pins 103, e.g. using a second object support 701. When the conditioning device 100 comprises the pre-conditioning module 300, the second object gripper 700 may also be adapted to receive the object 104 from the pre-conditioning module 300. Optionally, the second object gripper 700 is controlled by the control unit 120 which sends a control signal 138 via output terminal 120.8 to input terminal 700.1.

In an embodiment, the first object gripper 600 and/or the second object gripper 700 may be embodied similarly to support structure disclosed in US7486384B2 and/or comprise one or more features of said device. US7486384B2 is incorporated herein by reference.

It is noted that although only one object 104 is shown in fig. 4, in practice it may be possible that a first object 104 is arranged in the pre-conditioning volume 300 while a further object is arranged in the conditioning volume 100 and/or a further object is arranged above the object table 400. This may e.g. improve throughput.

Optionally, the pre-conditioning module 300 comprises a second conditioning volume 312 which is embodied analogously to the conditioning volume 100. In that case, conditioning device 100 thus comprises a second conditioning volume 312 which may e.g. be adapted to condition a second object in series with the object 104 when the object 104 is in the conditioning volume 112, wherein the second conditioning volume 312 is embodied analogously to the conditioning volume 112.

Fig. 5 shows another embodiment wherein the conditioning device 100 comprises a second conditioning volume 1112 adapted to condition a second object 1104 in parallel with the object 104 when the object 104 is in the conditioning volume 112, wherein the second conditioning volume 1112 is embodied analogously to the conditioning volume 112. By conditioning the object 104 and the second object 1104 in parallel, the throughput can be increased and/or the conditioning time can be increased, said conditioning time referring to the time that the object 104 is arranged in the conditioning volume 112 or the second object 1104 in the second conditioning volume 1112 while the respective first plate and second plate are in the object conditioning position. Increasing the conditioning time allows ensuring that the temperature of the object 104 or second object 1104 can be conditioned closer to a desired temperature. For example, the object 104 may be arranged in the conditioning volume 112 for 12 seconds. For example, the temperature of the object 104 may within approximately 70 mK of the predetermined temperature before being arranged in the conditioning volume 112, and e.g. within 1.5 mK when being removed from the conditioning volume 112.

In the context of the embodiments above, it is noted that the second conditioning volume 312, 1112 being embodied analogously to the conditioning volume 112 is to be understood as meaning that any feature or embodiment that has been explained herein with reference to the conditioning device 100 with the conditioning volume 112 may also be applied to the second conditioning volume 312, 1112. It further noted that it may be possible to provide further conditioning volumes being embodied analogously to the conditioning volume 112 for conditioning further objects in series or parallel, e.g. a third, and/or a fourth, and/or a fifth, and/or a sixth conditioning volume.

In the examples shown in fig. 2a-5, a single control unit 120 is provided for several functionalities, such as receiving the distance information 134 and the detection signal 136, and controlling the pump 151, the support pin actuator 114, actuator unit 105, the first object gripper 600 and the second object gripper 700. It will be appreciated, however, that it is also possible to provide multiple control units for performing one or more of these functionalities.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A conditioning device for conditioning an object in a conditioning volume, comprising:
• at least one support pin adapted to support the object,
• a first plate and a second plate forming outer borders of the conditioning volume,
• an actuator unit adapted to move at least one of the first plate and the second plate, between:
• an object receiving position in which the first plate and second plate are separated by a receiving distance of each other and the object can be arranged into the conditioning volume, and
• an object conditioning position in which the first plate and second plate are separated by a conditioning distance of each other which is smaller than the receiving distance, wherein a seal is formed between the first plate and the second plate in the object conditioning position, wherein the seal forms an outer border of the conditioning volume.

2. Conditioning device according to claim 1, wherein the seal is a mechanical seal and/or a labyrinth seal, which is formed by the first plate and/or second plate when the first plate and/or the second plate are arranged in the object conditioning position.

3. Conditioning device according to any of the preceding claims, further comprising a control unit, wherein the control unit:
• comprises an input terminal adapted to receive distance information representing a warpage of the object and/or an orientation of the object relative to the first plate and/or second plate, and
• is configured to determine a desired conditioning distance based on the distance information and control the actuator unit to arrange the first plate and/or second plate in the object conditioning position based on the desired conditioning distance.

4. Conditioning device according to claim 3, further comprising a warpage measuring unit adapted to determine the distance information and adapted to send the distance information to the input terminal of the control unit.

5. Conditioning device according to any of the preceding claims, further comprising a control unit configured to control the supply of the conditioning fluid such that the pressure inside the conditioning volume, during operational use, can reach between 600-2000 Pa.

6. Conditioning device according to any of the preceding claims,
wherein in the object receiving position a receiving opening is provided between the first plate and the second plate for arranging the object between the first plate and the second plate, wherein the receiving opening is between 10-20 mm,
and/or
wherein the conditioning distance is between 1-2 mm.

7. Conditioning device according to any of the preceding claims,
wherein the first plate and/or the second plate are conditioning plates,
and/or
wherein the conditioning device further comprises a liquid conditioning system adapted to condition the first plate and/or the second plate.

8. Conditioning device according to any of the preceding claims, wherein the at least one support pin comprises one, two, three, four, five, or six support pins.

9. Conditioning device according to any of the preceding claims, wherein the object is a reticle, a substrate or a wafer.

10. Conditioning device according to any of the preceding claims, further comprising a second conditioning volume adapted to condition a second object in parallel or in series with the object when the object is in the conditioning volume, wherein the second conditioning volume is embodied analogously to the conditioning volume.

11. Object handler comprising a conditioning device according to any of the preceding claims and an object pre-alignment module adapted to determine and/or control a position the object while it is being conditioned in the conditioning volume.

12. Object handler according to claim 11, wherein the object pre-alignment module comprises a plurality of illuminators with each a corresponding camera for determining a position of the object, wherein the illuminators are each adapted to emit a measurement beam and each camera is adapted to receive the measurement beam emitted by the corresponding illuminator, wherein the first plate and/or the second plate comprise at least one beam-transparent region through which the measurement beams can travel.

13. Lithographic apparatus comprising a stage apparatus for receiving an object comprising a substrate, said stage apparatus comprising an object table, an object handler according to any of the claims 11-12, and an object gripper adapted to receive the object from the object handler and arrange the object above the object table, wherein the lithographic apparatus is adapted to project a pattern from a patterning device onto the substrate.

14. Method for conditioning an object in a conditioning device comprising a conditioning volume, wherein the method comprises the following steps:
• arranging the object on at least one support pin while a first plate and a second plate which form outer borders of the conditioning volume are in an object receiving position in which the first plate and second plate are separated by a receiving distance of each other,
• arranging the first plate and/or the second plate in an object conditioning position in which the first plate and second plate are separated by a conditioning distance of each other which is smaller than the receiving distance, wherein a seal is formed between the first plate and the second plate in the object conditioning position, wherein the seal forms an outer border of the conditioning volume,
• removing the object from the conditioning device.

15. Method according to claim 14,
wherein the object is removed from the conditioning device after 4-15 seconds after inserting the object in the conditioning device, and/or
wherein the object is removed from the conditioning device when a temperature of the object is within 3 mK of a predetermined temperature.
